# EUROPEAN PATENT SPECIFICATION

(11) **EP 2 747 161 B1**
(45) Date of publication and mention of the grant of the patent: **16.12.2020**
(21) Application number: 13168181.9
(22) Date of filing: 17.05.2013
(51) Int. Cl.: H01L 51/50, H01L 51/54

(54) **Organic light emitting diode**
Organische lichtemittierende Diode
Diode électroluminescente organique

(30) Priority: 21.12.2012 CN 201210566199
(43) Date of publication of application: 25.06.2014
(73) Proprietor: Xiamen Tianma Micro-Electronics Co., Ltd., 361101 Xiamen (CN)
(72) Inventor: Lin, Wenjing, 361101 Xiamen (CN)
(74) Representative: HGF

(56) References cited:
- EP-A1- 2 166 589
- US-A1- 2009 091 255
- US-A1- 2010 052 527

## Description

### Technical Field

The present invention relates to the field of photovoltaic technologies, in particular, to an organic light emitting diode.

### Technical Background

An Organic Light Emitting Diode (OLED) emits light when an organic film is applied with a voltage, and is increasingly widely used in flat panel displays, illuminations, and backlights.

Nowadays, a White Organic Light Emitting Diode (WOLED) with a common phosphorescent material possesses poor stability due to the lack of a good dark blue phosphorescent material therein. Also, a WOLED of a structure with combined phosphorescence and fluorescence utilizes both singlet excitons and triplet excitons, but the singlet excitons (i.e. fluorescent excitons) are different from the triplet excitons (i.e. phosphorescent excitons) in terms of an energy property and a transfer property, and a charge recombination zone is moved depending on the voltage, so that the WOLED has a complex structure, a low energy utilization and a low light emitting efficiency, and more particularly, an optical spectrums of a WOLED device is severely changed along with the voltage, which leads to a poor color stability.

US 2009/091255 A1, EP 2 166 589 A1 and US 2010/052527 A1 all disclose light emitting diodes having a first phosphorescent layer, a blue fluorescent layer and a second phosphorescent layer.

### Summary of the Invention

An object of the present invention is to propose an OLED with improved color stability.

It is disclosed by the present invention an OLED including a substrate, an anode, a hole transport layer, a light emitting layer, an electron transport layer, and a cathode;
where the light emitting layer includes a first phosphorescent light emitting layer, a blue fluorescent light emitting layer, and a second phosphorescent light emitting layer, which are stacked along a direction from the anode to the cathode; and
a material capable of conducting holes and blocking electrons is employed in the first phosphorescent light emitting layer as its host material, and a material capable of conducting electrons and blocking holes is employed in the second phosphorescent light emitting layer as its host material, and a material capable of conducting both holes and electrons is employed in the blue fluorescent light emitting layer;
the first phosphorescent light emitting layer is a green phosphorescent light emitting layer formed by doping a guest material of tris(2-phenylpyridine)iridium (Ir(ppy)₃) into a host material of 4,4'-cyclohexylidenebis[N,N-bis(4-methylphenyl)aniline] (TAPC) at a molar ratio of 7%; and
the second phosphorescent light emitting layer is a red phosphorescent light emitting layer formed by doping a guest material of tris(2-phenylquinoline)iridium (Ir(2-phq)₃) into a host material of 2,9-dimethyl-4,7-diphenyl-1,10-phenanthroline (BCP) at a molar ratio of 8%.

Preferably, the blue fluorescent light emitting layer is an organic light emitting material layer of 4,4'-bis(2,2-diphenylvinyl)biphenyl (DPVBi).

Preferably, a thickness of each of the blue fluorescent light emitting layer, the first phosphorescent light emitting layer, and the second phosphorescent light emitting layer is of a range from 5nm to 20nm.

Preferably, the blue fluorescent light emitting layer has a thickness of 10nm, the first phosphorescent light emitting layer has a thickness of 10nm, and the second phosphorescent light emitting layer has a thickness of 12nm.

4,4'-cyclohexylidenebis[N,N-bis(4-methylphenyl)aniline] (TAPC) is employed in the first phosphorescent light emitting layer as its host material.

The first phosphorescent light emitting layer is a green phosphorescent light emitting layer formed by doping a guest material of tris(2-phenylpyridine)iridium (Ir(ppy)₃) into a host material of TAPC at a molar ratio of 7%.

2,9-dimethyl-4,7-diphenyl-1,10-phenanthroline (BCP) is employed in the second phosphorescent light emitting layer as its host material.

The second phosphorescent light emitting layer is a red phosphorescent light emitting layer formed by doping a guest material of tris(2-phenylquinoline)iridium (Ir(2-phq)₃) into the host material of BCP at a molar ratio of 8%.

The first and the second phosphorescent light emitting layers are of different colors.

The first and the second phosphorescent light emitting layers are a green phosphorescent light emitting layer and a red phosphorescent light emitting layer, respectively.

Preferably, the OLED further includes a hole injection layer provided between the anode and the hole transport layer, and an electron injection layer provided between the cathode and the electron transport layer.

Preferably, the host material of the first phosphorescent light emitting layer is the same as the material of the hole transport layer.

Preferably, the host material of the second phosphorescent light emitting layer is the same as the material of the electron transport layer.

Preferably, the OLED further includes:
a first exciton constraining layer, which is a layer of material capable of conducting holes and blocking electrons and provided between the light emitting layer and the hole transport layer; and
a second exciton constraining layer, which is a layer of material capable of conducting electrons and blocking holes and provided between the light emitting layer and the electron transport layer.

In the present invention, by providing the phosphorescent light emitting layers having a function of restricting charges, the exciton recombination zone is constrained in the blue fluorescent light emitting layer, so that the fluorescent excitons with a short diffusion distance are all utilized by the blue fluorescent light emitting layer and the phosphorescent excitons with a longer diffusion distance are all utilized by the phosphorescent light emitting layer, thereby achieving the isolated distribution of the excitons in corresponding light emitting layers and improving the light emitting efficiency and light stability of the OLED.

### Description of Drawings

Figure 1 is a schematic diagram of the structure of an OLED according to a first embodiment of the present invention;
Figure 2 is a schematic diagram of the structure the OLED according to another implementation of the first embodiment of the present invention;
Figure 3 is a schematic diagram of the structure of the OLED according to a second embodiment of the present invention; and
Figure 4 is a schematic diagram of the structure of the OLED according to a third embodiment of the present invention.

### Detailed description of the Preferred Embodiment

The technical solution of the present invention will be further described by way of embodiments below in conjunction with the accompanying drawings.

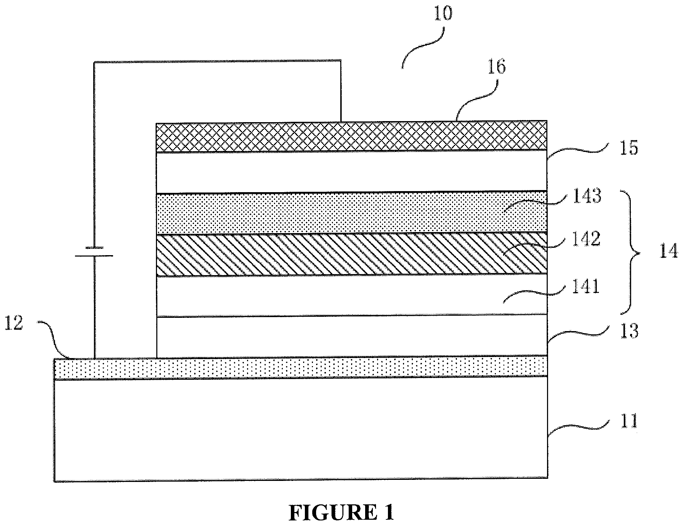

Figure 1 is a schematic diagram of the structure of an OLED according to a first embodiment of the present invention. As shown in Figure 1, the OLED 10 includes a substrate 11, an anode 12, a hole transport layer 13, a light emitting layer 14, an electron transport layer 15, and a cathode 16, which are stacked.

The light emitting layer 14 includes a first phosphorescent light emitting layer 141, a blue fluorescent light emitting layer 142, and a second phosphorescent light emitting layer 143, which are stacked along a direction from the anode to the cathode.

Here, a material capable of conducting holes and blocking electrons is employed in the first phosphorescent light emitting layer 141 as its host material, a material capable of conducting electrons and blocking holes is employed in the second phosphorescent light emitting layer 143 as its host material, and a material capable of conducting both electrons and holes is employed in the blue fluorescent light emitting layer 142.

The first and the second phosphorescent light emitting layers 141, 143 are of different colors. The first and the second phosphorescent light emitting layers 141, 143 are a green phosphorescent light emitting layer and a red phosphorescent light emitting layer, respectively.

When a current is applied to the OLED, holes are injected to the light emitting layer 14 by the anode 12 through the hole transport layer 13, and electrons are injected to the light emitting layer 14 by the cathode 16 through the electron transport layer 15. The injected holes and electrons are respectively transferred towards electrodes with opposite charges. When an electron and a hole are localized at the same molecule, an "exciton", i.e., a localized electron-hole pair of an excited energy state, is formed. Light is emitted due to a radiation transition during the transfer of the exciton from an excited state back to a ground state. When electrons and holes meet each other, their recombination results in excitons, of which 25% are singlet excitons and 75% are triplet excitons. The radiation transition from the excited singlet state to the ground state causes the emission of the fluorescent light, and the radiation transition from the excited triplet state to the ground state causes the emission of the phosphorescent light. The phosphorescent light emitting process is a transition involving the change of spin multiplicity and is constrained by a spin factor, thus its transition rate is much lower than that in the fluorescent emitting process. Accordingly, the triplet exciton can travel a longer distance due to its longer life. Further, the fluorescent material in the organic light emitting material can emit the fluorescent light merely by means of radiation attenuation of the singlet excitons, while the phosphorescent material in the organic light emitting material can emit the phosphorescent light by means of radiation attenuation of the triplet excitons.

In this embodiment, the first phosphorescent light emitting layer 141 is designed to be a layer of material capable of conducting holes and blocking electrons, and the second phosphorescent light emitting layer 143 is designed to be a layer of material capable of conducing electrons and blocking holes. The first phosphorescent light emitting layer 141 is provided at the side of the blue fluorescent light emitting layer 142 away from the cathode, and the second phosphorescent light emitting layer 143 is provided at the side of the blue fluorescent light emitting layer 142 away from the anode. Therefore, the holes injected from the anode into the blue fluorescent light emitting layer 142 can be blocked by the second phosphorescent light emitting layer 143, and hence cannot be further moved to the cathode; meanwhile, the electrons injected from the cathode into the blue fluorescent light emitting layer 142 can be blocked by the first phosphorescent light emitting layer 141, and hence cannot be further moved to the anode, thus, the electrons and the holes are restricted in the blue fluorescent light emitting layer 142 for combination, that is, the exciton recombination zone is constrained in the blue fluorescent light emitting layer 142, so that most excitons are generated in the blue fluorescent light emitting layer 142. In this case, the fluorescent excitons (i.e. singlet excitons) can be utilized by the fluorescent material in the blue fluorescent light emitting layer, since they cannot pass through the blue fluorescent light emitting layer 142 to reach the phosphorescent light emitting layers due to their short lives. On the contrary, the phosphorescent excitons (i.e. triplet excitons) can be utilized by the phosphorescent material in the phosphorescent light emitting layer, since they can pass through blue fluorescent light emitting layer 142 due to their long lives which lead to long diffusion distances. Therefore, both the singlet excitons and the triplet excitons can be better utilized, thus improving the light emitting efficiency of the device.

In designing the structure of the OLED, the thicknesses of the first phosphorescent light emitting layer and the second phosphorescent light emitting layer may be adjusted to control the distribution of the excitons (i.e., energy) in the light emitting layer, thereby adjusting the brightness and other color characteristics of various primary colors, in order to achieve the white balance or other desired effect.

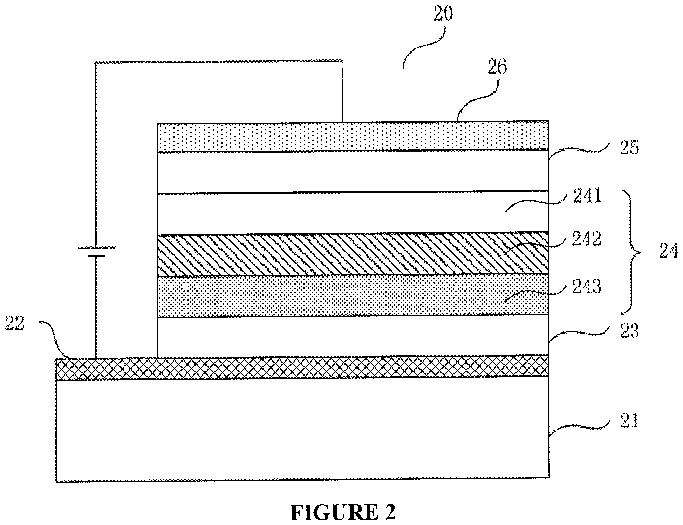

In another implementation of this embodiment, as shown in Figure 2, an OLED 20 includes a substrate 21, a cathode 22, an electron transport layer 23, a light emitting layer 24, a hole transport layer 25, and an anode 26, which are stacked. That is, the anode 26 is located on the top of the OLED 20. The OLED 20 may be referred as an "inverted" OLED, since common OLEDs are mostly constructed with a structure in which the cathode is located above the anode. Correspondingly, the light emitting layer 24 includes a first phosphorescent light emitting layer 241, a blue fluorescent light emitting layer 242, and a second phosphorescent light emitting layer 243, which are stacked along a direction from the anode to the cathode.

Here, a material capable of conducting holes and blocking electrons is employed in the first phosphorescent light emitting layer 241 as its host material, a material capable of conducting electrons and blocking holes is employed in the second phosphorescent light emitting layer 243 as its host material, and a material capable of conducting both electrons and holes is employed in the blue fluorescent light emitting layer 242. In the "inverted" OLED, only corresponding modification and selection of the material constituting the cathode and the anode is required, for example, a metal layer with a thickness of 10-20nm formed by any one or composition of Ag and Mg is employed as a transparent cathode, and a metal layer with a larger thickness formed by any one or composition of Ag and Mg is employed as a semitransparent anode.

In this embodiment, by providing the structure of the phosphorescent light emitting layers which has a function of restricting charges, the exciton recombination zone is constrained in the blue fluorescent light emitting layer, so that the fluorescent excitons with a short diffusion distance are all utilized by the blue fluorescent light emitting layer and the phosphorescent excitons with a longer diffusion distance are all utilized by the phosphorescent light emitting layer, thereby achieving the isolated distribution of the excitons in corresponding light emitting layers and improving the light emitting efficiency and light stability of the OLED.

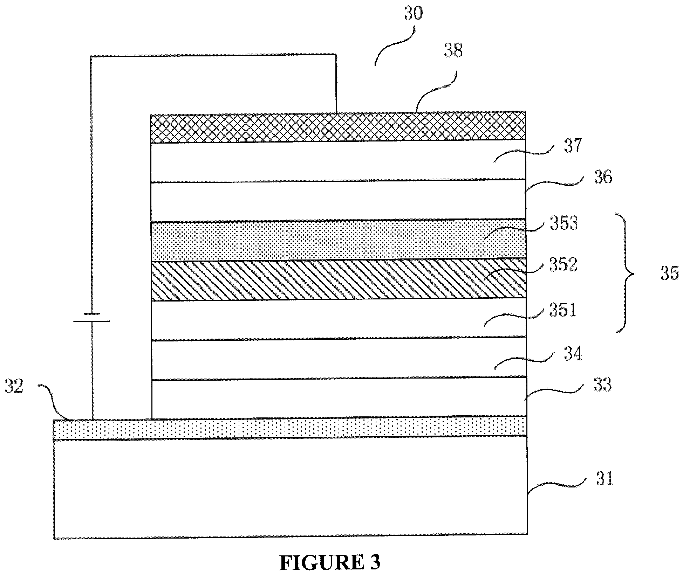

Figure 3 is a schematic diagram of the structure of an OLED according to a second embodiment of the present invention. As shown in Figure 3, the OLED 30 according to the second embodiment of the present invention includes a substrate 31, an anode 32, a hole injection layer 33, a hole transport layer 34, a light emitting layer 35, an electron transport layer 36, an electron injection layer 37, and a cathode 38, which are stacked.

The light emitting layer 35 is formed with a composite structure, which includes a first phosphorescent light emitting layer 351, a blue fluorescent light emitting layer 352, and a second phosphorescent light emitting layer 353, which are stacked along a direction from the anode to the cathode.

Here, a material capable of conducting holes and blocking electrons is employed in the first phosphorescent light emitting layer as its host material, a material capable of conducting electrons and blocking holes is employed in the second phosphorescent light emitting layer as its host material, and a material capable of conducting both electrons and holes is employed in the blue fluorescent light emitting layer.

In the preferred implementation of the present embodiment, the anode 32 is embodied as a film of Indium Tin Oxide (ITO), Indium Zinc Oxide (IZO), or other transparent conductive materials.

The hole injection layer 33 is formed by 4,4',4"-tris(3-methylphenylphenylamino)-triphenylamine (m-MTDATA), and preferably has a thickness of 10nm.

The hole transport layer 34 is formed by 4,4'-cyclohexylidenebis[N,N-bis (4-methylphenyl)aniline] (TAPC), and preferably has a thickness of 30nm
The electron transport layer 36 and electron injection layer 37 each are formed by 2,9-dimethyl-4,7-diphenyl-1,10-phenanthroline (BCP), and preferably have thicknesses of 30nm.

The cathode 38 is formed with a composite cathode structure, which is formed preferably by a Lithium Fluoride (LiF) layer having a thickness of 1nm and an Aluminum (Al) layer located thereon.

The light emitting layer 35 is formed with a composite structure including: the first phosphorescent light emitting layer in which a material of TAPC capable of conducting holes is employed as its host material, and the second phosphorescent light emitting layer in which a material of 2,9-dimethyl-4,7-diphenyl-1,10-phenanthroline (BCP) capable of conducting electrons is employed as its host material. That is, in this embodiment, the host material of the first phosphorescent light emitting layer is the same as the material of the hole transport layer, and the host material of the second phosphorescent light emitting layer is the same as the material of the electron transport layer.

The first phosphorescent light emitting layer is formed as a green light emitting layer, which is a green phosphorescent light emitting layer formed by doping a guest material of tris(2-phenylpyridine)iridium (Ir(ppy)₃) into the host material of TAPC at a molar ratio of 7%, and
the second phosphorescent light emitting layer is formed as a red light emitting layer, which is a red phosphorescent light emitting layer formed by doping a guest material of tris(2-phenylquinoline)iridium (Ir(2-phq)₃) into the host material of BCP at a molar ratio of 8%.

The blue fluorescent light emitting layer 352 is formed by 4,4'-bis(2,2-diphenylvinyl)biphenyl (DPVBi), and has a thickness of 5-20nm, and preferably a thickness of 10nm. It can be understood by those skilled in the art that, the blue fluorescent light emitting layer 352 can also be formed by other organic fluorescent light emitting material.

In this implementation, the first phosphorescent light emitting layer, the blue fluorescent light emitting layer, and the second phosphorescent light emitting layer are formed as green, blue and red primary-color light emitting layers, respectively, to emit white light.

In other embodiments, not forming part of the invention, the first and the second phosphorescent light emitting layers can be of same color or different colors, the colors being different from those mentioned in claim 1. For instance, the first and the second phosphorescent light emitting layers may be phosphorescent light emitting layers with a color complementary to blue, for example, yellow or red phosphorescent light emitting layers, to eventually emit white light. If the OLED is intended to emit light of another desired color, the first and the second phosphorescent light emitting layers can also be embodied as primary-color light emitting layers which emit light to be combined with blue color to obtain the desired color.

In this embodiment, the first phosphorescent light emitting layer, the blue fluorescent light emitting layer, and the second phosphorescent light emitting layer have thicknesses of a range from 5nm to 20nm, and preferably the first phosphorescent light emitting layer has a thickness of 10nm, the blue fluorescent light emitting layer has a thickness of 10nm, and the second phosphorescent light emitting layer has a thickness of 12nm.

It should be understood by those skilled in the art that, the materials and thicknesses thereof employed by the above OLEDs are illustrated merely for the exemplary description of the specific implementations of the present invention. Other alternative known materials with the same function may be selected by the skilled in the art based on a limited number of tests to form the corresponding material layers, and the thicknesses of the different layers in the composite light emitting layers may be adjusted to achieve the desired light effect.

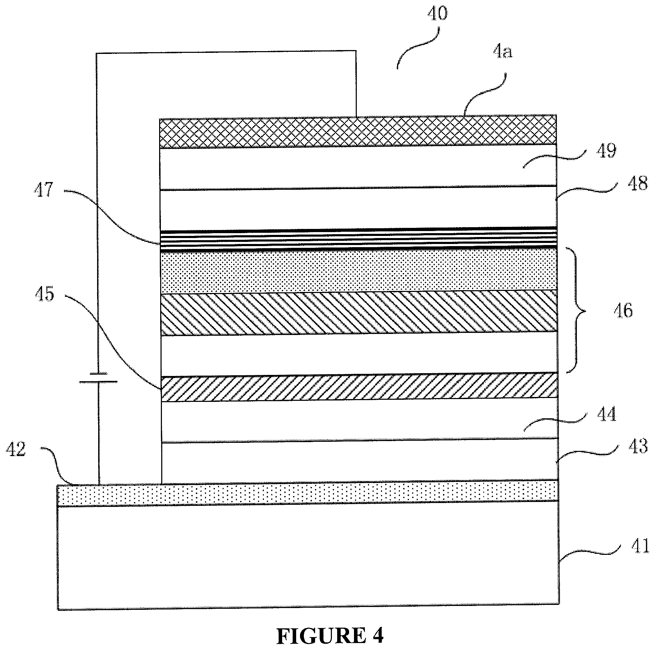

Figure 4 is a schematic diagram of the structure of an OLED according to a third embodiment of the present invention. As shown in Figure 4, the OLED 40 according to the third embodiment of the present invention includes a substrate 41, an anode 42, a hole injection layer 43, a hole transport layer 44, a first exciton constraining layer 45, a light emitting layer 46, a second exciton constraining layer 47, an electron transport layer 48, an electron injection layer 49, and a cathode 4a, which are stacked. That is, the OLED 40 according to the third embodiment is additionally provided with the first exciton constraining layer 45 and the second exciton constraining layer 47 compared with that of the second embodiment. The first exciton constraining layer 45 and the second exciton constraining layer 47 are a layer of material capable of conducting holes and blocking electrons and a layer of material capable of conducting electrons and blocking holes, respectively. Thus, electrons moved from the cathode to the anode in Figure 4, after being subjected to blocking by a first isolation layer of the light emitting layer 46, can also be blocked by the first exciton constraining layer 45 even if passing through the first isolation layer, so that the electrons are recombined with the holes in the light emitting layer 46. Likewise, holes moved from the anode to the cathode in Figure 4, after being subjected to blocking by a second isolation layer of the light emitting layer 46, can also be blocked by the second exciton constraining layer 47 to stay in the light emitting layer 46 for recombining with the electrons even if passing through the second isolation layer. Thereby, the light emitting efficiency of the OLED is further improved.

In this embodiment, by providing the first and the second exciton constraining layers, the exciton recombination zone is further constrained in the light emitting layer, thereby further improving the light emitting efficiency of the OLED.

For those skilled in the art, various modifications and changes can be made for the present invention.

## Claims

1. An organic light emitting diode (10, 20, 30, 40), comprising a substrate (11, 21, 31, 41), an anode (12, 26, 32, 42), a hole transport layer (13, 25, 34, 44), a light emitting layer (14, 24, 35, 46), an electron transport layer (15, 23, 36, 48), and a cathode (16, 22, 38 4a) wherein, the light emitting layer (14, 24, 35, 46) comprises a first phosphorescent light emitting layer (141, 241, 351), a blue fluorescent light emitting layer (142, 242, 352), and a second phosphorescent light emitting layer (143, 243, 353), which are stacked along a direction from the anode to the cathode (16, 22, 38, 4a); a material capable of conducting holes and blocking electrons is employed in the first phosphorescent light emitting layer (141, 241, 351) as its host material, a material capable of conducting electrons and blocking holes is employed in the second phosphorescent light emitting layer (143, 243, 353) as its host material, and a material capable of conducting both holes and electrons is employed in the blue fluorescent light emitting layer (142, 242, 352); **characterised in that** the first phosphorescent light emitting layer (141, 241, 351) is a green phosphorescent light emitting layer formed by doping a guest material of tris(2-phenylpyridine)iridium (Ir(ppy)₃) into a host material of 4,4'-cyclohexylidenebis[N,N-bis (4-methylphenyl)aniline] (TAPC) at a molar ratio of 7%; and the second phosphorescent light emitting layer (143, 243, 353) is a red phosphorescent light emitting layer formed by doping a guest material of tris(2-phenylquinoline)iridium (Ir(2-phq)₃) into a host material of 2,9-dimethyl-4,7-diphenyl-1,10-phenanthroline (BCP) at a molar ratio of 8%.

2. The organic light emitting diode (10, 20, 30, 40) of claim 1, wherein, the blue fluorescent light emitting layer (142, 242, 352) is an organic light emitting material layer of 4,4'-bis(2,2-diphenylvinyl)biphenyl (DPVBi).

3. The organic light emitting diode (10, 20, 30, 40) of claim 1, wherein, a thickness of each of the blue fluorescent light emitting layer (142, 242, 352), the first phosphorescent light emitting layer (141, 241, 351), and the second phosphorescent light emitting layer (143, 243, 353) is of a range from 5nm to 20nm.

4. The organic light emitting diode (10, 20, 30, 40) of claim 3, wherein, the blue fluorescent light emitting layer (142, 242, 352) has a thickness of 10nm, the first phosphorescent light emitting layer (141, 241, 351) has a thickness of 10nm, and the second phosphorescent light emitting layer (143, 243, 353) has a thickness of 12nm.

5. The organic light emitting diode (10, 20, 30, 40) of claim 1, further comprising a hole injection layer (33, 43) provided between the anode (12, 26, 32, 42) and the hole transport layer (13, 25, 34, 44), and an electron injection layer (37, 49) provided between the cathode (16, 22, 38, 4a) and the electron transport layer (15, 23, 36, 48).

6. The organic light emitting diode (10, 20, 30, 40) of claim 5, wherein, the host material of the first phosphorescent light emitting layer i (141, 241, 351) is the same as the material of the hole transport layer (13, 25, 34, 44).

7. The organic light emitting diode (10, 20, 30, 40) of claim 5, wherein, the host material of the second phosphorescent light emitting layer i (143, 243, 353) is the same as the material of the electron transport layer (15, 23, 36, 48).

8. The organic light emitting diode (10, 20, 30, 40) of claim 5, further comprising:
a first exciton constraining layer (45), which is a layer of material capable of conducting holes and blocking electrons and provided between the light emitting layer (14, 24, 35, 46) and the hole transport layer (13, 25, 34, 44); and
a second exciton constraining layer (47), which is a layer of material capable of conducting electrons and blocking holes and provided between the light emitting layer (14, 24, 35, 46) and the electron transport layer (15, 23, 36, 48).

## Patentansprüche

1. Organische lichtemittierende Diode (10, 20, 30, 40) mit einem Substrat (11, 21, 31, 41), einer Anode (12, 26, 32, 42), einer Löchertransportschicht (13, 25, 34, 44), einer lichtemittierenden Schicht (14, 24, 35, 46), einer Elektronentransportschicht (15, 23, 36, 48) und einer Kathode (16, 22, 38, 4a), wobei
die lichtemittierende Schicht (14, 24, 35, 46) eine erste phosphoreszierende lichtemittierende Schicht (141, 241, 351), eine blaue fluoreszierende lichtemittierende Schicht (142, 242, 352) und eine zweite phosphoreszierende lichtemittierende Schicht (143, 243, 353) aufweist, die entlang einer Richtung von der Anode zur Kathode (16, 22, 38, 4a) übereinandergestapelt sind;
ein Material, das in der Lage ist, Löcher zu leiten und Elektronen zu blockieren, in der ersten phosphoreszierenden lichtemittierenden Schicht (141, 241, 351) als ihr Host-Material verwendet wird, ein Material, das in der Lage ist, Elektronen zu leiten und Löcher zu blockieren, in der zweiten phosphoreszierenden lichtemittierenden Schicht (143, 243, 353) als ihr Host-Material verwendet wird, und ein Material, das in der Lage ist, sowohl Löcher als auch Elektronen zu leiten, in der blauen fluoreszierenden lichtemittierenden Schicht (142, 242, 352) verwendet wird;
**dadurch gekennzeichnet, dass** die erste phosphoreszierende lichtemittierende Schicht (141, 241, 351) eine grüne phosphoreszierende lichtemittierende Schicht ist, die gebildet wird, indem ein Gastmaterial aus Tris(2-phenylpyridin)-Iridium (Ir(ppy)₃) in ein Host-Material aus 4-4'-Cyclohexylidenbis[N,N-bis (4-methylphenyl)-Anilin] (TAPC) bei einem molaren Verhältnis von 7% über einen Dotiervorgang eingebracht wird; und
die zweite phosphoreszierende lichtemittierende Schicht (143, 243, 353) eine rote phosphoreszierende lichtemittierende Schicht ist, die gebildet wird, indem ein Gastmaterial aus Tris(2-phenylquinolin)-Iridium (Ir(2-phq)₃) in ein Host-Material aus 2,9-Dimethyl-4,7-diphenyl-1,10-phenanthrolin (BCP) bei einem molaren Verhältnis von 8% über einen Dotiervorgang eingebracht wird.

2. Organische lichtemittierende Diode (10, 20, 30, 40) nach Anspruch 1, wobei die blaue fluoreszierende lichtemittierende Schicht (142, 242, 352) eine organische lichtemittierende Materialschicht aus 4,4'-bis(2,2-diphenylvinyl)biphenyl (DPVBi) ist.

3. Organische lichtemittierende Diode (10, 20, 30, 40) nach Anspruch 1, wobei eine Dicke von jeweils der blauen fluoreszierenden lichtemittierenden Schicht (142, 242, 352), der ersten phosphoreszierenden lichtemittierenden Schicht (141, 241, 351) und der zweiten phosphoreszierenden lichtemittierenden Schicht (143, 243, 353) in einem Bereich von 5 nm bis 20 nm liegt.

4. Organische lichtemittierende Diode (10, 20, 30, 40) nach Anspruch 3, wobei die blaue fluoreszierende lichtemittierende Schicht (142, 242, 352) eine Dicke von 10 nm hat, die erste phosphoreszierende lichtemittierende Schicht (141, 241, 351) eine Dicke von 10 nm hat, und die zweite phosphoreszierende lichtemittierende Schicht (143, 243, 353) eine Dicke von 12 nm hat.

5. Organische lichtemittierende Diode (10, 20, 30, 40) nach Anspruch 1, darüber hinaus eine Löcherinjektionsschicht (33, 43) aufweisend, die zwischen der Anode (12, 26, 32, 42) und der Löchertransportschicht (13, 25, 34, 44) vorgesehen ist, und eine Elektroneninjektionsschicht (37, 49), die zwischen der Kathode (16, 22, 38, 4a) und der Elektronentransportschicht (15, 23, 36, 48) vorgesehen ist.

6. Organische lichtemittierende Diode (10, 20, 30, 40) nach Anspruch 5, wobei das Host-Material der ersten phosphoreszierenden lichtemittierenden Schicht (141, 241, 351) das gleiche ist wie das Material der Löchertransportschicht (13, 25, 34, 44).

7. Organische lichtemittierende Diode (10, 20, 30, 40) nach Anspruch 5, wobei das Host-Material der zweiten phosphoreszierenden lichtemittierenden Schicht (143, 243, 353) das gleiche ist wie das Material der Elektronentransportschicht (15, 23, 36, 48).

8. Organische lichtemittierende Diode (10, 20, 30, 40) nach Anspruch 5, darüber hinaus aufweisend:
eine erste Exzitonen-Beschränkungsschicht (45), die eine Materialschicht darstellt, welche in der Lage ist, Löcher zu leiten und Elektronen zu blockieren, und zwischen der lichtemittierenden Schicht (14, 24, 35, 46) und der Löchertransportschicht (13, 25, 34, 44) vorgesehen ist; und
eine zweite Exzitonen-Beschränkungsschicht (47), die eine Materialschicht darstellt, welche in der Lage ist, Elektronen zu leiten und Löcher zu blockieren, und zwischen der lichtemittierenden Schicht (14, 24, 35, 46) und der Elektronentransportschicht (15, 23, 36, 48) vorgesehen ist.

## Revendications

1. Diode électroluminescente organique (10, 20, 30, 40), comprenant un substrat (11, 21, 31, 41), une anode (12, 26, 32, 42), une couche de transport de trous (13, 25, 34, 44), une couche électroluminescente (14, 24, 35, 46), une couche de transport d'électrons (15, 23, 36, 48), et une cathode (16, 22, 38, 4a), sachant que
la couche électroluminescente (14, 24, 35, 46) comprend une première couche électroluminescente phosphorescente (141, 241, 351), une couche électroluminescente fluorescente bleue (142, 242, 352), et une deuxième couche électroluminescente phosphorescente (143, 243, 353), lesquelles sont empilées le long d'une direction allant de l'anode à la cathode (16, 22, 38, 4a) ;
un matériau capable de conduire les trous et de bloquer les électrons est utilisé dans la première couche électroluminescente phosphorescente (141, 241, 351) en tant que son matériau hôte, un matériau capable de conduire les électrons et de bloquer les trous est utilisé dans la deuxième couche électroluminescente phosphorescente (143, 243, 353) en tant que son matériau hôte, et un matériau capable de conduire à la fois les trous et les électrons est utilisé dans la couche électroluminescente fluorescente bleue (142, 242, 352) ;
**caractérisé en ce que** la première couche électroluminescente phosphorescente (141, 241, 351) est une couche électroluminescente phosphorescente verte formée par dopage d'un matériau invité de tris(2-phénylpyridine)iridium (Ir(ppy)₃) en un matériau hôte de 4,4'-cyclohexylidènebis[N,N-bis (4-méthylphényl)aniline] (TAPC) selon un rapport molaire de 7 % et
la deuxième couche électroluminescente phosphorescente (143, 243, 353) est une couche électroluminescente phosphorescente rouge formée par dopage d'un matériau invité de tris(2-phénylquinoline)iridium (Ir(2-phq)₃) en un matériau hôte de 2,9-diméthyl-4,7-diphényl-1,10-phénanthroline (BCP) selon un rapport molaire de 8 %.

2. La diode électroluminescente organique (10, 20, 30, 40) de la revendication 1, sachant que la couche électroluminescente fluorescente bleue (142, 242, 352) est une couche de matériau électroluminescent organique de 4,4'-bis(2,2-diphénylvinyl)biphényle (DPVBi).

3. La diode électroluminescente organique (10, 20, 30, 40) de la revendication 1, sachant qu'une épaisseur de chacune de la couche électroluminescente fluorescente bleue (142, 242, 352), de la première couche électroluminescente phosphorescente (141, 241, 351), et de la deuxième couche électroluminescente phosphorescente (143, 243, 353) est comprise dans une plage de 5 nm à 20 nm.

4. La diode électroluminescente organique (10, 20, 30, 40) de la revendication 3, sachant que la couche électroluminescente fluorescente bleue (142, 242, 352) a une épaisseur de 10 nm, la première couche électroluminescente phosphorescente (141, 241, 351) a une épaisseur de 10 nm, et la deuxième couche électroluminescente phosphorescente (143, 243, 353) a une épaisseur de 12 nm.

5. La diode électroluminescente organique (10, 20, 30, 40) de la revendication 1, comprenant en outre une couche d'injections de trous (33, 43) disposée entre l'anode (12, 26, 32, 42) et la couche de transport de trous (13, 25, 34, 44), et une couche d'injection d'électrons (37, 49) disposée entre la cathode (16, 22, 38, 4a) et la couche de transport d'électrons (15, 23, 36, 48).

6. La diode électroluminescente organique (10, 20, 30, 40) de la revendication 5, sachant que le matériau hôte de la première couche électroluminescente phosphorescente (141, 241, 351) est le même que le matériau de la couche de transport de trous (13, 25, 34, 44).

7. La diode électroluminescente organique (10, 20, 30, 40) de la revendication 5, sachant que le matériau hôte de la deuxième couche électroluminescente phosphorescente (143, 243, 353) est le même que le matériau de la couche de transport d'électrons (15, 23, 36, 48).

8. La diode électroluminescente organique (10, 20, 30, 40) de la revendication 5, comprenant en outre :
une première couche de confinement d'excitons (45), qui est une couche de matériau capable de guider les trous et de bloquer les électrons et qui est disposée entre la couche électroluminescente (14, 24, 35, 46) et la couche de transport de trous (13, 25, 34, 44) ; et
une deuxième couche de confinement d'excitons (47), qui est une couche de matériau capable de conduire les électrons et de bloquer les trous et qui est disposée entre la couche électroluminescente (14, 24, 35, 46) et la couche de transport d'électrons (15, 23, 36, 48).
